(19) Europäisches Patentamt

European Patent Office

Office européen des brevets

(11) **EP 1 037 267 A1**

(12) **EUROPEAN PATENT APPLICATION**
published in accordance with Art. 158(3) EPC

(43) Date of publication:
20.09.2000 Bulletin 2000/38

(51) Int. Cl.7: **H01L 21/027**, G03F 7/20

(21) Application number: 98951711.5

(86) International application number:
**PCT/JP98/04999**

(22) Date of filing: 06.11.1998

(87) International publication number:
**WO 99/25008 (20.05.1999 Gazette 1999/20)**

(84) Designated Contracting States:
**DE NL**

(30) Priority: 07.11.1997 JP 32248297

(71) Applicant: **Nikon Corporation**
**Tokyo 100-0005 (JP)**

(72) Inventors:
• **SUZUKI, Kenji**
**Chiyoda-ku, Tokyo 100-0005 (JP)**

• **MORI, Takashi**
**Chiyoda-ku, Tokyo 100-0005 (JP)**

(74) Representative:
**Steil, Christian, Dipl.-Ing. et al**
**Witte, Weller & Partner,**
**Postfach 10 54 62**
**70047 Stuttgart (DE)**

(54) **PROJECTION EXPOSURE DEVICE, PROJECTION EXPOSURE METHOD, AND METHOD OF MANUFACTURING PROJECTION EXPOSURE DEVICE**

(57) An exposure device with a higher resolution, comprising a light source(1), an illumination optical system(3) for illuminating a pattern on a projection reticle(R) by a light beam from the light source(1), and a projection optical system(4) for projecting the image of the pattern on a photosensitive surface on a photosensitive wafer(W), wherein the light source(1) supplies light whose wavelength is shorter than 193 nm, a band narrowing device(2) which narrows the bandwidth of the spectrum of the light supplied by the light source (1), is provided, and the projection optical system includes a plurality of refractive optical devices all made of $CaF_2$

**FIG. 1**

**Description**

BACKGROUND OF THE INVENTION

Field of the Invention

The present invention relates to a projection exposure apparatus used for transferring a mask(projection original) pattern onto a substrate(work) in a lithography process for manufacturing a device such as a semiconductor device, an imaging device, a flat panel display device(e.g. a liquid crystal display device), a thin-film magnetic head, etc.. The present invention also relates to a projection exposure method of projecting the mask pattern on the substrate in the lithography process. The present invention further relates to a method of manufacturing the projection exposure apparatus.

Related Background Arts

With a higher integration of the semiconductor device, a projection exposure apparatus used in a photolithography manufacturing process thereof has achieved its remarkable progresses over the recent years.
A resolution R of the projection exposure apparatus utilizing the light is, as known by way of the Rayleigh's formula, expressed such:

$$R = c \cdot \lambda/Na$$

where $\lambda$ is an exposure wavelength, NA is an image-side numerical aperture of the projection optical system, and c is a constant determined by a process, such as a resolution of a resist. The higher integration of the semiconductor device is actualized by making the pattern much hyperfiner, and hence, for resolving the hyperfiner pattern, as obvious from the formula given above, it is required that the exposure wavelength $\lambda$ be shortened and NA of the exposure light be increased.
Over the recent years, 0.35 $\mu$m line-and-space processing has been attained by use of a projection optical system having a numerical aperture of 0.6, wherein 365 nm lines of a mercury lamp serve as a light source. This makes it possible to attain a photolithography-based mass production of a 64 Mbit random access memory. Further, a development of an exposure apparatus is underway, wherein the light source is a krypton fluoride (KrF) excimer laser ($\lambda$ = 248 nm) or an argon fluoride (ArF) excimer laser ($\lambda$ = 193 nm). Processing of 0.25 ~ 0.18 $\mu$m line-and-space, which is required of a 256 Mbit or 1 Gbit random access memory class, is on the verge of its actualization by light.
The conventional technology is, however, limited in resolving power to the 0.25 ~ 0.18 $\mu$m line-and-space processing, and, if aiming at resolving power of a 0.1 $\mu$m class over this, it is required that the exposure wavelength be made by far shorter, and the numerical aperture NA of the exposure light be further increased, or there be combined a variety of super resolution techniques. If scheming to enhance the resolution by increasing NA of the exposure light among those schemes, this might lead to a rapid scale-up of the projection optical system and might need an optical material required to exhibit a high uniformity and a high accuracy as well. That scheme might be forced to have an extremely large difficulty in processing of the optical material, and be poor of reality if based on the premise of its mass production. Further, the variety of super resolution techniques proposed at the present have a strong dependency upon the pattern and therefore impose a large restraint on a circuit design, so that there must be no alternative but to take a step backward for entirely adopting them.
On the other hand, there are active pursuits for systems using energies other than the light such as X-rays, electron beams, etc., and, if the photolithography eventually encounters the limit, it follows that technology will shift to those systems. A predominance of the light is absolute in the field of the exposure apparatus, and there must be a necessity for a crucial motivation for shifting to other systems by venturing upon a cutoff of extensions of know-how and technologies accumulated through the researches and experiences over the past long years.
After all, it may be said that a farther pursuit for the limit of shortening the wavelength in the photography is only one way of overcoming all the difficulties.

SUMMARY OF THE INVENTION

It is an object of the present invention to provide a projection exposure apparatus exhibiting much finer resolving power. It is another object of the present invention to provide a projection exposure method of exposing a photosensitive substrate to the light via a pattern formed on a projection original(e.g. mask, reticle). It is a further object of the present invention to provide a method of manufacturing the projection exposure apparatus.
The present inventors made researches cumulatively in order to obviate the above problems, and put an emphasis, to start with, upon a fluorine dimer($F_2$) laser by way of one example of a light source, of which an oscillation wavelength is shorter than an ArF excimer laser beam ($\lambda$ = 193 nm) but is not so short as no available refractive optical material exists, and from which a practical output can be obtained. According to a literature (Ohara: "Extreme Ultraviolet Laser", Optics, 23 (1994) 626-627), the oscillation wavelength of the $F_2$ laser is 157 nm, and this is a laser light source capable of obtaining an output of an MW(Mega Watt) class or larger. Besides, the $F_2$ laser has such a characteristic that a spectral width thereof is as narrow as 1 ~ 5 pm even if a band narrowing device is not used.

Next, in the optical system of which the light source is the ArF excimer laser, synthetic silica glass ($SiO_2$) and a calcium fluoride crystal ($CaF_2$) are usable as refractive optical materials. In an area of 157 nm of the $F_2$ laser, a transmissivity of $SiO_2$ is extremely declines, and therefore this synthetic silica glass is hard to use as the refractive optical material. An absorption end of $CaF_2$ is, however, on the order of 122 nm at a normal temperature (G. Cheroff and S.P. Keller: "Measurements of Rise and Decay Timers of Stimulated Emission from Phosphors", J.Opt. Soc. Am, 47, 440-441 (1957)), and hence there is a possibility in which $CaF_2$ can be used in 157 nm.

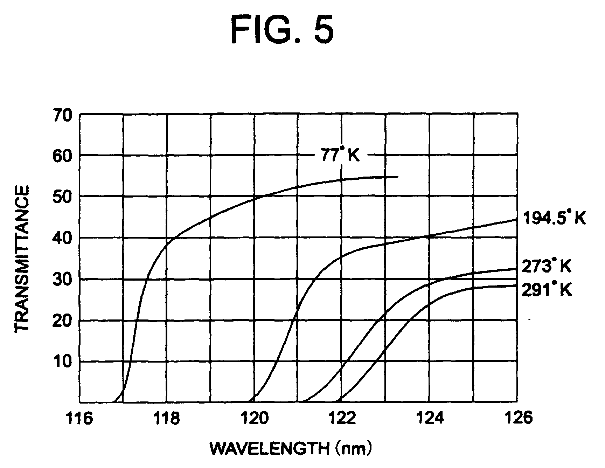

Such being the case, the present inventors tentatively measured the transmissivity of $CaF_2$ in the extreme ultraviolet region. FIG. 5 shows one example of the measured result. As shown in FIG. 5, $CaF_2$ exhibits substantially a fixed transmissivity with respect the light of 157 nm. It is considered that the transmissivity is by far enhanced by further restraining a defect in oxygen in $CaF_2$, and hence eventually $CaF_2$ is, it can be said, usable for the light of 157 nm.

Next, it is required for designing the projection optical system in fact that there be known a refractive index n and a dispersion $dn/d\lambda$ of $CaF_2$ in 157 nm. Then, the refractive index n and the dispersion $dn/d\lambda$ of $CaF_2$ in 157 nm are obtained by extrapolating a dispersion formula (I.H. Malitson: "A redetermination of Some Optical Properties of Calcium Fluoride", Appl. Opt. 2(1963), 1103-1107) obtained in the area up to 185 nm.

Further, as a comparative example, the refractive index n and the dispersion $dn/d\lambda$ of $SiO_2$ in each of 248 nm and 193 nm are obtained based on another literature (I.M. Malitson, "Interspecimen Comparison of Refractive Index of Fused Silicat", J. Opt. Soc. Am, 35(1965), 1205-1209). The following is the result thereof.

$CaF_2$: 157 nm n= 1.55861104  $dn/d\lambda$ = -2.55 $\times$ 10$^{-3}$
$SiO_2$: 248 nm n= 1.50855076  $dn/d\lambda$ = -5.61 $\times$ 10$^{-4}$
$SiO_2$: 193 nm n= 1.56076908  $dn/d\lambda$ = -1.29 $\times$ 10$^{-3}$

When using the KrF excimer laser beam ($\lambda$ = 248 nm) of which a spectral half bandwidth (full width half maximum) is on the order of 1 pm, a dispersion of $SiO_2$ is comparatively small, and hence there is almost no chromatic aberration even when constructing the projection optical system of all refractive system using only $SiO_2$ on condition that NA = 0.6 or thereabouts. Then using the ArF excimer laser beam ($\lambda$ = 193 nm), however, the dispersion of $SiO_2$ is comparatively large even when narrowing the spectral width down to approximately 1 pm, and it is therefore difficult to construct the projection optical system of the all refractive system using $SiO_2$, wherein the chromatic aberration is corrected by using $CaF_2$ in combination.

The dispersion of $CaF_2$ with respect to the $F_2$ laser beam ($\lambda$ = 157 nm) is substantially equal to the dispersion of $SiO_2$ in 193 nm as shown in the above table. Accordingly, in the case of constructing the projection optical system of the all refractive system using only $CaF_2$ in the region of 157 nm exhibiting a spectral width of approximately 1 pm, it is difficult to correct the chromatic aberration. This being the case, the $F_2$ laser is used as a light source, and, when employing the projection optical system of the all refractive system using only $CaF_2$, it can be understood that there is a necessity for scheming to narrow the band of the wavelength of the light source.

As to how much the band should be narrowed, a condition required of a half bandwidth $\Delta\lambda$ may be expressed such as:

$$\Delta\lambda \leqq k \cdot L/NA^2 \tag{1}$$

where $\Delta\lambda$ is the half bandwidth (full width half maximum) of a spectrum after the band has been narrowed, L is an inter-object-image distance (overall distance, conjugate distance) in the projection optical system, i.e., an axial distance between an object(a pattern surface of a projection original) and an image(photosensitive surface of a photosensitive substrate), NA is an image-side numerical aperture of the projection optical system, and k is a constant determined by specifications of the projection optical system.

According to the present invention devised based on the contemplation described above, a projection exposure apparatus comprises a light source;

an illumination optical system which illuminates a pattern on a projection original with a light flux emitted from the light source, and a projection optical system which forms a pattern image on a photosensitive surface of a photosensitive substrate. The light source supplies light beams having a wavelength shorter than 193 nm, and there is disposed a band narrowing device which narrows a band of a spectrum of light having a wavelength shorter than 193 nm, supplied from the light source. The projection optical system includes a plurality of refractive optical elements, and the refractive optical elements constituting the projection optical system are all consisting of $CaF_2$.

On this occasion, it is preferable that a band of light is narrowed to satisfy the following condition:

$$\Delta\lambda \leqq 7.0 \times 10^{-13} \cdot L/NA^2 \qquad\qquad (2)$$

where $\Delta\lambda$ is a half-width of a spectrum of the light supplied from the light source, L is a distance on the optical axis from a pattern surface on a projection original to a photosensitive surface of a photosensitive substrate, and NA is an image-side numerical aperture of the projection optical system.

According to the present invention, a projection exposure apparatus comprises an illumination optical system which illuminates a pattern on projection a original with a light flux emitted from a light source, and a projection optical system which projects a pattern image on a photosensitive substrate. The light source supplies light beams having a wavelength shorter than 193 nm, a band narrowing device which narrows a band of a spectrum of light having a wavelength shorter than 193 nm, supplied from the light source, is disposed, and the band narrowing device narrows the band of light emitted from the light source so as to satisfy the following condition:

$$\Delta\lambda \leqq 7.0 \times 10^{-13} \cdot L/NA^2$$

where $\Delta\lambda$ is a half-width of a spectrum of the light after the band thereof has been narrowed by the band narrowing device, L is a distance on the optical axis from a pattern surface on the projection original to the photosensitive surface of the photosensitive substrate, and NA is a photosensitive-substrate-side numerical aperture of the projection optical system.

Further, according to the present invention, a projection exposure apparatus comprises an illumination optical system which illuminates a pattern on a projection original with illumination light having a wavelength shorter than 193 nm, and a projection optical system which forms a pattern image on a photosensitive surface of a photosensitive substrate. The illumination optical system supplies the illumination light having such a spectral width as to satisfy the following condition:

$$\Delta\lambda \leqq 7.0 \times 10^{-13} \cdot L/NA^2$$

where $\Delta\lambda$ is a half-width of a spectrum of the illumination light given from the illumination optical system, L is a distance from a pattern surface on the projection original to the photosensitive surface of the photosensitive substrate, and NA is a photosensitive-substrate-side numerical aperture of the projection optical system. The projection optical system is constructed of refractive optical elements.

According to the present invention, a projection exposure apparatus comprises an illumination optical system which illuminates a pattern on a projection original with illumination light having a wavelength shorter than 193 nm, and a projection optical system which forms a pattern image on a photosensitive surface of a photosensitive substrate. The projection optical system is constructed of only refractive optical elements, and the illumination optical system supplies the illumination light having such a spectral width that a Strehl intensity on an image surface of the projection optical system is 0.8 or larger.

According to the present invention, a projection exposure method comprises a step of supplying light having a wavelength shorter than 193 nm, a step of narrowing a band of the light, a step of guiding the band-narrowed light to a projection original having a predetermined pattern and illuminating the projection original with the light, and a step of forming a pattern image on a photosensitive surface of a photosensitive substrate by use of a projection optical system including a plurality of refractive optical elements, wherein all the refractive optical elements in the projection optical system are composed of $CaF_2$.

According to the present invention, a projection exposure method comprises a step of supplying light having a wavelength shorter than 193 nm, a step of narrowing a band of a spectrum of the light having the wavelength shorter than 193 nm, a step of illuminating a pattern on a projection original with the band-narrowed light, and a step of projecting a pattern image on a photosensitive substrate by use of a projection optical system, The band of light is narrowed to satisfy the following condition:

$$\Delta\lambda \leqq 7.0 \times 10^{-13} \cdot L/NA^2$$

where $\Delta\lambda$ is a half-width of the spectrum of the light after the band thereof has been narrowed in the band narrowing step. L is a distance from a pattern surface on the projection original to the photosensitive surface of the photosensitive substrate, and NA is a photosensitive-substrate-side numerical aperture of the projection optical system.

According to the present invention, a projection exposure method comprises a step of illuminating a pattern on a projection original with illumination light having a wavelength shorter than 193 nm, and a step of forming a pattern image on a photosensitive surface of a photosensitive substrate by a projection optical system. The illuminating step involves supplying the illumination light having such a spectral width as to satisfy the following condition:

$$\Delta\lambda \leqq 7.0 \times 10^{-13} \cdot L/NA^2$$

where $\Delta\lambda$ is a half-width of a spectrum of the illumination light given from the illumination optical system, L is a distance from a pattern surface on the projection original to the photosensitive surface of the photosensitive substrate, and NA is a photosensitive-substrate-side numerical aperture of the projection optical system, and the projecting step involves guiding the light from the projection original to the photosensitive substrate via only refractive optical elements.

According to the present invention, a method of manufacturing a projection exposure apparatus comprises a step of preparing an illumination optical system which illuminates a pattern on a projection original with illumination light having a wavelength shorter than 193 nm, and a step of preparing a projection optical system which forms a pattern image on a photosensitive surface of a photosensitive substrate by a projection optical system. The illumination optical system is constructed to supply the illumination light having such a spectral width as to satisfy the following condition:

$$\Delta\lambda \leqq 7.0 \times 10^{-13} \cdot L/NA^2$$

where $\Delta\lambda$ is a half-width of a spectrum of the illumination light given from the illumination optical system, L is a distance from a pattern surface on the projection original to the photosensitive surface of the photosensitive substrate, and NA is a photosensitive-substrate-side numerical aperture of the projection optical system. The projection optical system preparing step includes a sub-step of preparing a plurality of refractive optical elements, and a sub-step of assembling the plurality of refractive optical elements. The method further comprises a step of assembling the illumination optical system and the projection optical system.

Brief Description of Drawings

FIG. 1 is a schematic view showing an exposure apparatus in one embodiment of the present invention;
FIG. 2 is a sectional view showing a geometry of lenses of a projection optical system in the embodiment;
FIGS. 3A to 3E are diagram showing aberrations of the projection optical system in the embodiment;
FIG. 4 is a graph showing a relationship between a full width half maximum of a spectrum of light and a Strehl intensity when an image height is 0; and
FIG. 5 is a graph showing a transmittance of $CaF_2$ in an extreme ultraviolet region.

DESCRIPTION OF THE PREFERRED EMBODIMENTS

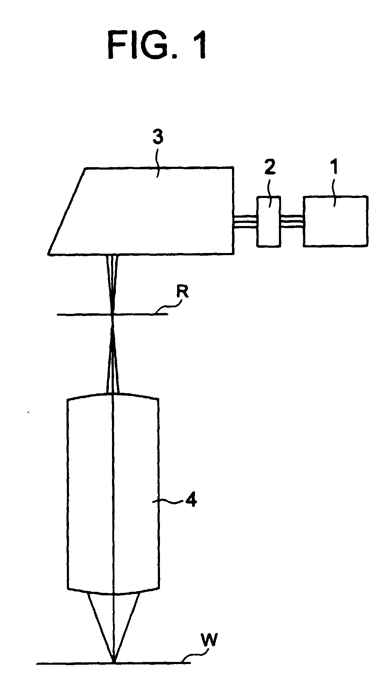

An embodiment of the present invention will be described with reference to the drawings. FIG. 1 shows one embodiment of a projection exposure apparatus according to the present invention. This projection exposure apparatus includes a light source 1, a band narrowing device 2 which narrows a band of a light flux emitted from the light source 1, an illumination optical system 3 which substantially illuminates a pattern on a reticle R defined as a projection original with the light flux of which the band-width is narrowed by the band narrowing device 2, and a projection optical system 4 which forms an image of the pattern on the reticle R, on a photosensitive surface of a wafer W defined as a photosensitive substrate. In this embodiment, the light source 1 involves the use of an $F_2$ laser, and the projection optical system 4 involves the use of a dioptric optical system consisting of only $CaF_2$.

Note that refractive optical elements (a lens element, plane-parallel plane, etc.) used for the illumination optical system 3 are all cosisting of $CaF_2$ (fluorite), and a gas within the illumination optical system 3 is substituted by helium gas. Further, in the projection optical system 4 also, a gas within the projection optical system 4 is substituted by helium gas. Moreover, a space extending from the light source 1 to the illumination optical system 3, a space between the illumination optical system 3 and the projection optical system 4, and a space between the projection optical system 4 and the wafer W, are also substituted by helium gas.

Further, in this embodiment, there is used the reticle composed of any one of calcium fluoride (fluorite), synthetic silica doped with fluorine, magnesium fluoride, and quartz-crystal.

The wafer W having undergone an exposure process (a photolithography process) by the exposure apparatus in the present embodiment shown in FIG. 1, receives, after a developing process, an etching process of etching a developed area excluding a resist to a thickness required and further a resist removing process of removing the unnecessary resist after the etching process, thus finishing the wafer process. Then, upon the end of the wafer process, there are executed a dicing process of dicing the wafer into chips per circuit printed in an actual assembly process, a bonding process of arranging wires on the chips, and a packaging process of packaging per chip. Through these processes, a semiconductor device (LSI, etc.) is eventually manufactured. Note that what has been described so far shows the case of manufacturing the semiconductor device by the photolithography process in the wafer process using the exposure apparatus, however, a flat panel display device such as a liquid crystal display panel, a thin-film magnetic head and an imaging element (CCD, etc.) may also be manufactured as microelectronic devices.

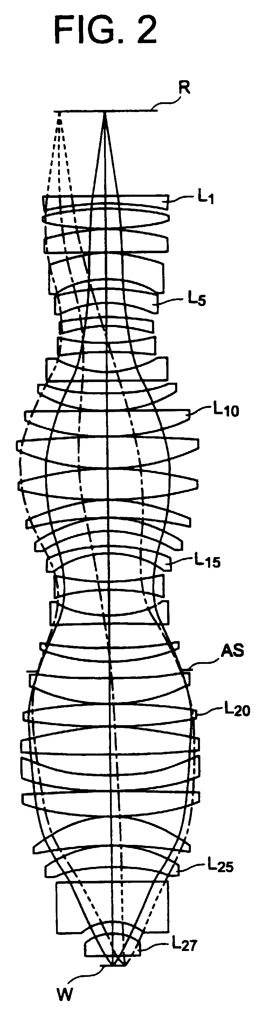

FIG. 2 is a sectional view showing a geometry of lenses of the projection optical system 4. As shown in FIG. 2, in the projection optical system 4 in this embodiment, twenty seven pieces of lenses $L_1 \sim L_{27}$ are used for convenience, and an aperture stop AS is disposed between the lens $L_{18}$ and the lens $L_{19}$.

Table 1 given as follows shows lens data and general system data of the projection optical system 4. In the lens data, a first column indicates a serial number of lens surfaces from the side of the reticle R, a second column "r" indicates a radius of curvature of each lens surface (the value is positive when the center of curvature exists in a light traveling direction), a third column "d" represents a spacing on the optical axis from one lens surface to the next lens surface to, and a fourth column represents a serial number of each lens.

A dispersion $dn/d\lambda$ and a refractive index n of $CaF_2$ when the wavelength $\lambda = 157$ nm, as already described, take the following values.

$$n = 1.55861104$$

$$dn/d\lambda = -2.55 \times 10^{-3}$$

(Table 1)

[General System Data]

f (Focal Length) : $\infty$

NA (Image-Side Numerical Aperture) : 0.6

Y (Maximum Image Height) : 13.2 mm

L (Inter-Object-Image-Distance) : 1000 mm

$\beta$ (Magnification) : -0.25


[Lens Data]

| | r | d | |
|---|---|---|---|
| 0 | $\infty$ | 95.00237 | R |
| 1 | 1382.43500 | 9.99995 | $L_1$ |
| 2 | 290.56564 | 6.88854 | |
| 3 | 337.30930 | 22.83077 | $L_2$ |
| 4 | -228.40397 | 0.99995 | |
| 5 | 223.96164 | 26.60343 | $L_3$ |
| 6 | 5638.10100 | 0.99996 | |
| 7 | 173.41102 | 29.85645 | $L_4$ |
| 8 | 108.75761 | 10.28911 | |
| 9 | 201.84587 | 16.93097 | $L_5$ |
| 10 | 118.14040 | 16.54418 | |
| 11 | 245.26889 | 9.99994 | $L_6$ |
| 12 | 140.95817 | 21.01889 | |
| 13 | -186.53319 | 9.99996 | $L_7$ |

| 14 | 408.48572 | 24.86013 | |
| 15 | $-98.85823$ | 9.99995 | $L_8$ |
| 16 | $-1314.91100$ | 13.74699 | |
| 17 | $-235.69460$ | 20.32360 | $L_9$ |
| 18 | $-150.48008$ | 0.99996 | |
| 19 | $-1228.13900$ | 29.08275 | $L_{10}$ |
| 20 | $-225.05918$ | 0.99996 | |
| 21 | 2054.03400 | 36.68527 | $L_{11}$ |
| 22 | $-246.05895$ | 0.99994 | |
| 23 | 369.75733 | 37.47410 | $L_{12}$ |
| 24 | $-402.21348$ | 0.99994 | |
| 25 | 200.19852 | 20.35150 | $L_{13}$ |
| 26 | 348.66335 | 1.23517 | |
| 27 | 139.73373 | 15.12963 | $L_{14}$ |
| 28 | 135.63799 | 17.51748 | |
| 29 | 155.75169 | 9.99993 | $L_{15}$ |
| 30 | 105.66389 | 33.28534 | |
| 31 | $-216.81489$ | 9.99994 | $L_{16}$ |
| 32 | 202.60530 | 30.30447 | |
| 33 | $-111.55047$ | 9.99994 | $L_{17}$ |
| 34 | 2557.24500 | 27.46258 | |
| 35 | $-427.54395$ | 16.64567 | $L_{18}$ |
| 36 | $-207.78315$ | 10.83833 | |
| 37 | $\infty$ | 7.95573 | A S |
| 38 | $-693.74216$ | 29.12054 | $L_{19}$ |

| 39 | $-210.50921$ | 0.99994 | |
| 40 | 645.10721 | 25.44942 | $L_{20}$ |
| 41 | $-564.81681$ | 0.99994 | |
| 42 | 349.77884 | 33.19497 | $L_{21}$ |
| 43 | $-1234.38200$ | 24.59543 | |
| 44 | $-218.84429$ | 17.99995 | $L_{22}$ |
| 45 | $-335.23355$ | 0.99995 | |
| 46 | 2803.58200 | 28.67252 | $L_{23}$ |
| 47 | $-315.15601$ | 0.99994 | |
| 48 | 129.77179 | 33.28217 | $L_{24}$ |
| 49 | 400.41135 | 0.99993 | |
| 50 | 137.57804 | 23.37237 | $L_{25}$ |
| 51 | 186.79413 | 14.30647 | |
| 52 | 786.26228 | 48.20673 | $L_{26}$ |
| 53 | 52.81944 | 13.41916 | |
| 54 | 49.25582 | 25.05940 | $L_{27}$ |
| 55 | 501.39939 | 13.46716 | |
| 56 | $\infty$ | | $W$ |

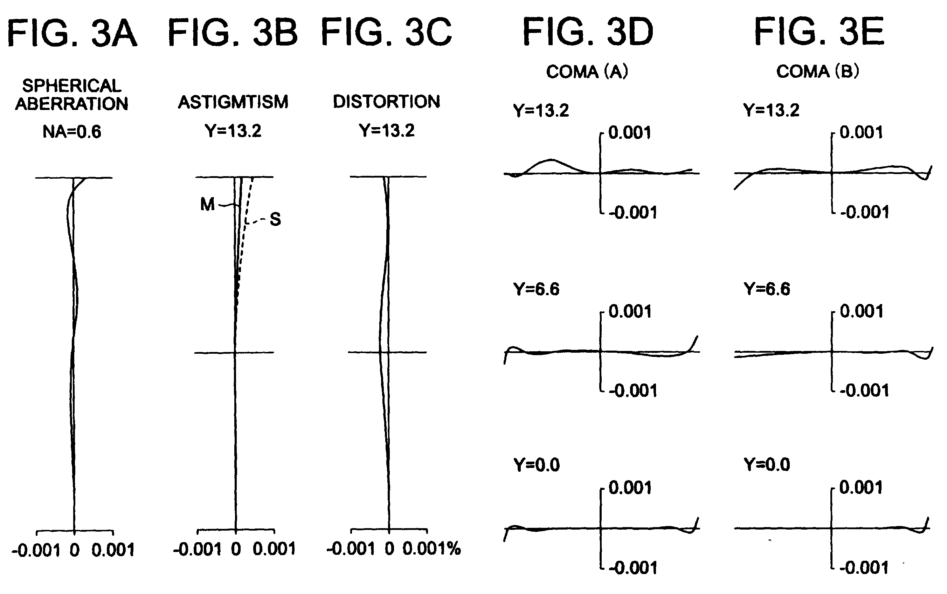

FIGS. 3A - 3E show a spherical aberration, an astigmatism, a distortion and a coma of the projection optical system in this embodiment. In each aberration graph, NA represents the image-side numerical aperture, and Y denotes the image height. In the astigmatism graph, the solid line M represents a meridional image surface, and the dotted line indicates a sagittal image surface. Further, the coma (A) indicates a transverse aberration of the meridional rays. Moreover, a right half of the coma (B) indicates a transverse aberration in the sagittal direction of the sagittal rays, while a left half thereof represents a transverse aberration in the meridional direction of the sagittal rays.

As obvious from the respective aberration graphs, it can be understood that the projection optical system in this embodiment exhibits an excellent image forming performance.

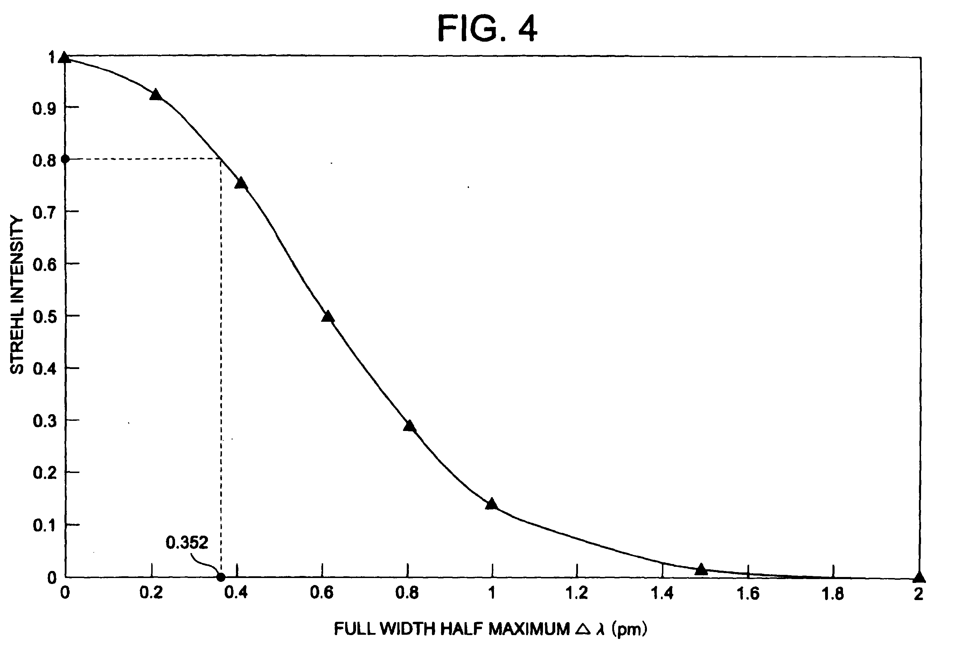

FIG. 4 shows a relationship between a Strehl intensity and a half-width $\Delta\lambda$ of a light spectrum when the image height is 0 (Y = 0). According to the Marechel criterion, if the Strehl intensity exceeds 0.8, it may be conceived that there is no aberration. In FIG. 4, a requirement for attain a Strehl intensity of 0.8 or larger is:

$$\Delta\lambda \leqq 0.352 \text{ pm} \qquad (3)$$

Therefore, from the formulae (1) and (3), the overall distance L is given such as L = 1000 mm, and the numerical aperture NA is given by NA = 0.6, and hence k is given by:

9

$$k = 1.27 \times 10^{-13}$$

Accordingly, the formula (1) becomes:

$$\Delta\lambda \leqq 1.27 \times 10^{-13} \cdot L/NA^2 \tag{4}$$

Namely, it is preferable that a band of wavelength of the light source is narrowed to satisfy the condition (4).

The k's value ($= 1.27 \times 10^{-13}$) in the above conditions is a value given when using the projection optical system of which the data are shown in Table 1, and, if changing the geometry of the projection optical system, may be varied corresponding thereto.

Further, in the above discussion, the projection optical system constructed of the refractive optical members has been exemplified, but the present invention is not limited to this construction. For example, the projection optical system may be constructed of a combination of the refractive optical members and reflection type optical members (a concave mirror, a convex mirror), which is a so-called catadioptric system. In this case also, the k's value takes a predetermined value.

Thus, when considering the case where the projection optical system is constructed of the refractive optical members and a case of being constructed of the catadioptric system, it is preferable that the k's value meets the following condition (5):

$$k \leqq 7.0 \times 10^{-13} \tag{5}$$

If the projection optical system is constructed to satisfy the above condition (5), it is feasible to obtain sufficient effects of the present invention.

Hence, the condition (1) given above turns out:

$$\Delta\lambda \leqq 7.0 \times 10^{-13} \cdot L/NA^2 \tag{2}$$

If the projection optical system is constructed to meet this condition (2), it is possible to actualize the exposure apparatus having a high resolution while well correcting the various aberrations including a chromatic aberration. Further, when the exposure apparatus satisfying the condition (2) exposes the reticle pattern onto the photosensitive substrate, whereby a preferable semiconductor device can be manufactured.

Now, the projection exposure apparatus in the embodiment described above can be manufactured by the following method. To start with, there is prepared the illumination optical system which illuminates the pattern on the reticle with the illumination light having a wavelength shorter than 193 nm. In this case, the illumination optical system is so constructed as to supply the illumination light having such a spectral width as to satisfy the condition (2) given above. Then, the projection optical system which forms an image of the reticle pattern on the photosensitive surface of the photosensitive substrate, is prepared. What this projection optical system is prepared may involve preparing and assembling a plurality of refractive optical elements. Then, the illumination optical system and the projection optical system are connected to each other electrically, mechanically or optically in order to attain the function described above, thereby assembling the projection exposure apparatus in this embodiment.

Further, in accordance with the embodiment discussed above, the projection optical system 4 is constructed of the refractive optical member, and $CaF_2$ (calcium fluoride) is used for this optical member. In addition to or as a substitute for $CaF_2$, the projection optical system 4 may be composed of a single kind of optical material, or plural kinds of optical materials by use of fluoride crystalline materials such as, e.g., barium fluoride, lithium fluoride and magnesium fluoride, and silica doped with fluoride. If capable of sufficiently narrowing the band of the illumination light illuminating the reticle R, however, it is preferable that the projection optical system 4 be composed of the single kind of optical material. Moreover, taking facilitation of manufacturing the projection optical system and manufacturing costs into consideration, it is preferable that the projection optical system 4 be consisting of only $CaF_2$.

Note that the space throughout the optical path from the light source to the wafer is substituted by the helium gas in the embodiment discussed above, however, some proportion or all of the space along the optical path may be substituted by a nitrogen ($N_2$) gas, or a vacuum atmosphere may also be available.

Moreover, the light source involves the use of the $F_2$ laser, and the spectral width is narrowed by the band narrowing device. Instead, however, there may also be used higher harmonics of a solid-stage laser such as a YAG laser having an oscillation spectrum in 157 nm. Further, there may be used higher harmonics in which infrared band or visible band single wavelength laser beams oscillated from a DFB semiconductor laser or a fiber laser, are amplified a fiber amplifier into which, e.g., erbium (or both of erbium and yttrium) is doped, and are wavelength-converted into ultraviolet radiation by use of non-linear optical crystal.

Assuming that an oscillation wavelength of the single wavelength laser be within a range of, e.g., 1.51 ~ 1.59

μm, there are outputted tenth harmonic of which a wavelength occurred falls within a range of 151 ~ 159 nm. Supposing that especially the oscillation wavelength falls within a range of 1.57 ~ 1.58 μm, the tenth harmonic falling within the range of 157 ~ 158 nm, i.e., the ultraviolet radiation beams having substantially the same wavelength as that of the $F_2$ laser are obtained. Moreover, it is assumed that the oscillation wavelength be 1.03 ~ 1.12 μm, in which case there are outputted seventh harmonic of which the wavelength occurred is within a range of 147 ~ 160 nm. Supposing that particularly the oscillation wavelength falls within a range of 1.099 ~ 1.106 μm, there are obtained the seventh harmonic of which the wavelength occurred is within the range of 157 ~ 158 nm, i.e., the ultraviolet radiation beams having substantially the same wavelength as that of the $F_2$ laser. Incidentally, a yttrium doped fiber laser is used as the single wavelength oscillation laser.

Thus, in the case of using the harmonics given from the laser light source, because of being the spectral width (e.g., on the order of 0.01 pm) with the band of the higher harmonics themselves being sufficiently narrowed, that may be used in place of the light source 1 and the band narrowing device 2 in the embodiment described above.

Now, the embodiment discussed above can be applied to both of a step-and-repeat method (a batch exposure method) in which after the pattern image of the reticle R has been batchwise transferred to one single shot area on the wafer W, the wafer is moved within the plane orthogonal to the optical axis of the projection optical system 4, and the next shot area is moved to the exposure area of the projection optical system, thus performing the exposure, and a step-and-scan method (a scan exposure method) in which the reticle R and the wafer W are synchronously scanned with a projection magnification β serving as a speed ratio with respect to the projection optical system 4 when exposing each shot area on the wafer W. Note that what is required of the step-and-scan method is just to obtain a preferable image forming characteristic within a slit-shaped exposure area, and it is therefore feasible to expose a much wider shot area on the wafer W without a scale-up of the projection optical system PL.

Incidentally, there may be used the projection optical systems of not only a reduction system but also an unit magnification system or an enlargement system (such as, e.g., an exposure apparatus for manufacturing a liquid crystal display). Furthermore, the present invention can be applied to, in addition to the exposure apparatus used for manufacturing the semiconductor device, an exposure apparatus used for manufacturing display devices including the liquid crystal display device, an exposure apparatus for transferring a device pattern onto a glass plate, an exposure apparatus used for manufacturing a thin-film magnetic head, an exposure apparatus for transferring the device pattern onto a ceramic wafer, and an exposure apparatus used for manufacturing an imaging device (CCD, etc.). The present invention can be also applied to an exposure apparatus for transferring a circuit pattern onto a glass substrate or a silicon wafer in order to manufacture a reticle or a mask.

It is to be noted that the present invention is not limited to the embodiment discussed above and may take a variety of configurations without deviating from the gist of the present invention within the scope of the invention.

As discussed above, according to the present invention, it is possible to provide the exposure apparatus having the high resolution enough to preferably correct the various aberrations containing the chromatic aberration by use of the light source having the wavelength shorter than 193 nm. It is also feasible to manufacture the preferable semiconductor device by use of this exposure apparatus.

**Claims**

1. A projection exposure apparatus comprising:

   a light source;
   an illumination optical system which illuminates a pattern on a projection original plate with a light flux emitted from said light source; and
   a projection optical system which projects a pattern image on a photosensitive substrate,
   wherein said light source supplies light beams having a wavelength shorter than 193 nm,
   a band narrowing device for narrowing a band of a spectrum of light having a wavelength shorter than 193 nm, supplied from said light source, is disposed.
   said projection optical system includes a plurality of refractive optical elements, and
   said refractive optical elements constituting said projection optical system are all composed of $CaF_2$.

2. A projection exposure apparatus according to claim 1, wherein a band of light is narrowed to satisfy the following relationship:

$$\Delta\lambda \leq 7.0 \times 10^{-13} \cdot L/NA^2$$

where $\Delta\lambda$ is a half bandwidth of a spectrum of the light after the band thereof has been narrowed by said band narrowing device, L is a distance on the optical axis from a pattern surface on said projection original plate to the photosensitive surface of said photosensitive substrate, and NA is an image-side numerical aperture of said projection optical system.

3.  A projection exposure apparatus according to claim 2, wherein an $F_2$ excimer laser is used as said light source.

4.  A projection exposure apparatus according to claim 1, wherein an $F_2$ excimer laser is used as said light source.

5.  A projection exposure apparatus according to claim 1, wherein said projection optical system is constructed of only refractive optical elements.

6.  A projection exposure apparatus comprising:

    an illumination optical system which illuminates a pattern on a projection original plate with a light flux emitted from a light source; and
    a projection optical system which projects a pattern image on a photosensitive substrate,
    wherein said light source supplies light beams having a wavelength shorter than 193 nm,
    a band narrowing device for narrowing a band of a spectrum of light having a wavelength shorter than 193 nm, supplied from said light source, is disposed, and
    said band narrowing device narrows the band of light emitted from said light source so as to satisfy the following relationship:

    $$\Delta\lambda \leq 7.0 \times 10^{-13} \cdot L/NA^2$$

    where $\Delta\lambda$ is a half bandwidth of a spectrum of the light after the band thereof has been narrowed by said band narrowing device, L is a distance on the optical axis from a pattern surface on said projection original plate to the photosensitive surface of said photosensitive substrate, and NA is a photosensitive-substrate-side numerical aperture of said projection optical system.

7.  A projection exposure apparatus according to claim 6, wherein said projection optical system is constructed of only refractive optical elements.

8.  A projection exposure apparatus according to claim 6, wherein said projection optical system is composed of a single kind of optical material.

9.  A projection exposure apparatus comprising:

    an illumination optical system which illuminates a pattern on a projection original plate with illumination light having a wavelength shorter than 193 nm; and
    a projection optical system which forms a pattern image on a photosensitive surface of a photosensitive substrate,
    wherein said illumination optical system supplies the illumination light having such a spectral width as to satisfy the following relationship:

    $$\Delta\lambda \leq 7.0 \times 10^{-13} \cdot L/NA^2$$

    where $\Delta\lambda$ is a half bandwidth of a spectrum of the illumination light given from said illumination optical system, L is a distance from a pattern surface on said projection original plate to the photosensitive surface of said photosensitive substrate, and NA is a photosensitive-substrate-side numerical aperture of said projection optical system, and
    said projection optical system is constructed of refractive optical elements.

10. A projection exposure apparatus according to claim 9, wherein said projection optical system is composed of a single kind of optical material.

11. A projection exposure apparatus according to claim 10, wherein said refractive optical elements in said projection optical system are all composed of $CaF_2$.

12. A projection exposure apparatus according to claim 10, wherein said illumination optical system includes:

a light source which supplies the light having a wavelength shorter than 193 nm; and

a band narrowing device which narrows a band of the spectrum of the light supplied from said light source.

**13.** A projection exposure apparatus according to claim 9, wherein said illumination optical system includes:

a light source which supplies the light having a wavelength shorter than 193 nm; and

a band narrowing device which narrows a band of the spectrum of the light supplied from said light source.

**14.** A projection exposure apparatus according to claim 13, wherein an $F_2$ excimer laser is used as said light source.

**15.** A projection exposure apparatus according to claim 9, wherein said illumination optical system includes a light source unit for supplying higher harmonics of a laser which have a wavelength shorter than 193 nm.

**16.** A projection exposure apparatus comprising:

an illumination optical system which illuminates a pattern on a projection original plate with illumination light having a wavelength shorter than 193 nm; and

a projection optical system which forms a pattern image on a photosensitive surface of a photosensitive substrate,

wherein said projection optical system is constructed of only refractive optical elements, and

said illumination optical system supplies the illumination light having such a spectral width that a Strehl intensity on an image surface of said projection optical system is 0.8 or larger.

**17.** A projection exposure apparatus according to claim 16, wherein said projection optical system is composed of a single kind of optical material.

**18.** A projection exposure apparatus according to claim 17, wherein said refractive optical element in said projection optical system is $CaF_2$.

**19.** A projection exposure apparatus according to claim 17, wherein said illumination optical system supplies the illumination light having such a spectral width as to satisfy the following relationship:

$$\Delta\lambda \leqq 7.0 \times 10^{-13} \cdot L/NA^2$$

where $\Delta\lambda$ is a half bandwidth of a spectrum of the illumination light, L is a distance from a pattern surface on said projection original plate to the photosensitive surface of said photosensitive substrate, and NA is a photosensitive-substrate-side numerical aperture of said projection optical system.

**20.** A projection exposure apparatus according to claim 19, wherein said illumination optical system includes:

a light source which supplies the light having a wavelength shorter than 193 nm; and

a band narrowing device which narrows a band of a light flux supplied from said light source.

**21.** A projection exposure apparatus according to claim 16, wherein said illumination optical system includes a light source unit for supplying higher harmonics of a laser which have a wavelength shorter than 193 nm.

**22.** A projection exposure method comprising:

a step of supplying light having a wavelength shorter than 193 nm;

a step of narrowing a band of the light;

a step of guiding the band-narrowed light to a projection original plate having a predetermined pattern and illuminating said projection original plate with the light; and

a step of forming a pattern image on a photosensitive surface of a photosensitive substrate by use of a projection optical system including a plurality of refractive optical elements,

wherein all said refractive optical elements in said projection optical system are composed of $CaF_2$.

**23.** A projection exposure method according to claim 22, wherein the band of light is narrowed to satisfy the following relationship:

$$\Delta\lambda \leqq 7.0 \times 10^{-13} \cdot L/NA^2$$

where $\Delta\lambda$ is a half bandwidth of a spectrum of the light after the band thereof has been narrowed in said band narrowing step, L is a distance on the optical axis from a pattern surface on said projection original plate to the photosensitive surface of said photosensitive substrate, and NA is an image-side numerical aperture of said projection optical system.

24. A projection exposure method according to claim 23, wherein an $F_2$ excimer laser is used as said light source.

25. A projection exposure method according to claim 22, wherein an $F_2$ excimer laser is used as said light source.

26. A projection exposure method comprising:

a step of supplying light having a wavelength shorter than 193 nm;
a step of narrowing a band of a spectrum of the light having the wavelength shorter than 193 nm;
a step of illuminating a pattern on a projection original plate with the band-narrowed light; and
a step of projecting a pattern image on a photosensitive substrate by use of a projection optical system,
wherein the band of light is narrowed to satisfy the following relationship:

$$\Delta\lambda \leqq 7.0 \times 10^{-13} \cdot L/NA^2$$

where $\Delta\lambda$ is a half bandwidth of the spectrum of the light after the band thereof has been narrowed in said band narrowing step, L is a distance from a pattern surface on said projection original plate to the photosensitive surface of said photosensitive substrate, and NA is a photosensitive-substrate-side numerical aperture of said projection optical system.

27. A projection exposure method according to claim 26, wherein said projecting step involves guiding the light from said projection original plate to said photosensitive substrate via only refractive optical elements.

28. A projection exposure method according to claim 27, wherein an $F_2$ excimer laser is used as said light source.

29. A projection exposure method comprising:

a step of illuminating a pattern on a projection original plate with illumination light having a wavelength shorter than 193 nm; and
a step of forming a pattern image on a photosensitive surface of a photosensitive substrate by a projection optical system,
wherein said illuminating step involves supplying the illumination light having such a spectral width as to satisfy the following relationship:

$$\Delta\lambda \leqq 7.0 \times 10^{-13} \cdot L/NA^2$$

where $\Delta\lambda$ is a half bandwidth of a spectrum of the illumination light given from said illumination optical system, L is a distance from a pattern surface on said projection original plate to the photosensitive surface of said photosensitive substrate, and NA is a photosensitive-substrate-side numerical aperture of said projection optical system, and
said projecting step involves guiding the light from said projection original plate to said photosensitive substrate via only refractive optical elements.

30. A projection exposure method according to claim 29, wherein said projection optical system is composed of a single kind of optical material.

31. A projection exposure method according to claim 30, wherein said refractive optical elements in said projection optical system are all $CaF_2$ .

32. A projection exposure method according to claim 29, wherein said illuminating step includes a sub-step of supplying the light of which a wavelength is shorter than 193 nm, and a sub-step of narrowing the band of the spectrum of the light supplied.

**33.** A projection exposure method according to claim 32, wherein an $F_2$ excimer laser supplies the light of which the wavelength is shorter than 193 nm.

**34.** A projection exposure method according to claim 29, wherein said illuminating step includes a sub-step of supplying laser beams having a predetermined wavelength, and a sub-step of converting the laser beams into higher-harmonics having a wavelength shorter than 193 nm.

**35.** A method of manufacturing a projection exposure apparatus, comprising:

a step of preparing an illumination optical system which illuminates a pattern on a projection original plate with illumination light having a wavelength shorter than 193 nm; and
a step of preparing a projection optical system which forms a pattern image on a photosensitive surface of a photosensitive substrate by a projection optical system,
wherein said illumination optical system is constructed to supply the illumination light having such a spectral width as to satisfy the following relationship:

$$\Delta\lambda \leqq 7.0 \times 10^{-13} \cdot L/NA^2$$

wheret $\Delta\lambda$ is a half bandwidth of a spectrum of the illumination light given from said illumination optical system, L is a distance from a pattern surface on said projection original plate to the photosensitive surface of said photosensitive substrate, and NA is a photosensitive-substrate-side numerical aperture of said projection optical system,
said projection optical system preparing step includes a sub-step of preparing a plurality of refractive optical elements, and a sub-step of assembling said plurality of refractive optical elements, and
said method further comprises a step of assembling said illumination optical system and said projection optical system.

# FIG. 1

# FIG. 2

FIG. 3A FIG. 3B FIG. 3C

FIG. 3A
SPHERICAL ABERRATION
NA=0.6
-0.001 0 0.001

FIG. 3B
ASTIGMTISM
Y=13.2
S
M
-0.001 0 0.001

FIG. 3C
DISTORTION
Y=13.2
-0.001 0 0.001%

FIG. 3D
COMA (A)
Y=13.2   0.001 / -0.001
Y=6.6    0.001 / -0.001
Y=0.0    0.001 / -0.001

FIG. 3E
COMA (B)
Y=13.2   0.001 / -0.001
Y=6.6    0.001 / -0.001
Y=0.0    0.001 / -0.001

FIG. 4

# FIG. 5

# INTERNATIONAL SEARCH REPORT

| International application No. |
| --- |
| PCT/JP98/04999 |

| A. CLASSIFICATION OF SUBJECT MATTER |
| --- |
| Int.Cl⁶ H01L21/027, G03F7/20 |
| According to International Patent Classification (IPC) or to both national classification and IPC |

| B. FIELDS SEARCHED |
| --- |
| Minimum documentation searched (classification system followed by classification symbols)<br>Int.Cl⁶ H01L21/027, G03F7/20 |
| Documentation searched other than minimum documentation to the extent that such documents are included in the fields searched<br>Jitsuyo Shinan Koho 1922–1999 Toroku Jitsuyo Shinan Koho 1994–1999<br>Kokai Jitsuyo Shinan Koho 1971–1999 |
| Electronic data base consulted during the international search (name of data base and, where practicable, search terms used) |

| C. DOCUMENTS CONSIDERED TO BE RELEVANT | | |
| --- | --- | --- |
| Category* | Citation of document, with indication, where appropriate, of the relevant passages | Relevant to claim No. |
| Y | JP, 5-190425, A (Nikon Corp.),<br>30 July, 1993 (30. 07. 93),<br>Fig. 1 ; Par. No. [0034] (Family: none) | 1, 4, 5, 22, 25 |
| Y | JP, 8-107060, A (Nikon Corp.),<br>23 April, 1996 (23. 04. 96),<br>Par. No. [0005] (Family: none) | 1, 4, 5, 22, 25 |
| A | JP, 4-204904, A (Fujitsu Ltd.),<br>27 July, 1992 (27. 07. 92) (Family: none) | 1-35 |
| PA | JP, 10-59799, A (Nikon Corp.),<br>3 March, 1998 (03. 03. 98) (Family: none) | 1-35 |
| PA | JP, 10-197701, A (Nikon Corp.),<br>31 July, 1998 (31. 07. 98) (Family: none) | 1-35 |

| ☐ Further documents are listed in the continuation of Box C. | ☐ See patent family annex. |
| --- | --- |

| * Special categories of cited documents:<br>"A" document defining the general state of the art which is not considered to be of particular relevance<br>"E" earlier document but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |
| --- | --- |

| Date of the actual completion of the international search<br>2 February, 1999 (02. 02. 99) | Date of mailing of the international search report<br>9 February, 1999 (09. 02. 99) |
| --- | --- |
| Name and mailing address of the ISA/<br>Japanese Patent Office | Authorized officer |
| Facsimile No. | Telephone No. |

Form PCT/ISA/210 (second sheet) (July 1992)